Europäisches Patentamt

European Patent Office

Office européen des brevets

(19)

(11) **EP 0 762 211 A1**

(12) **EUROPÄISCHE PATENTANMELDUNG**

(43) Veröffentlichungstag:
12.03.1997 Patentblatt 1997/11

(51) Int. Cl.⁶: **G03F 7/115**

(21) Anmeldenummer: 96113802.1

(22) Anmeldetag: 29.08.1996

(84) Benannte Vertragsstaaten:
DE FR GB

(30) Priorität: 07.09.1995 DE 19533021

(71) Anmelder: HOECHST AKTIENGESELLSCHAFT
65926 Frankfurt am Main (DE)

(72) Erfinder:
• Brenn, Günter, Dr.
91052 Erlangen (DE)

• Durst, Franz, Prof. Dr. Dr.h.c.
91094 Langensendelbach (DE)
• Elsässer, Andreas, Dr.
65510 Idstein (DE)
• Gaschler, Otfried, Dipl.-Ing.
65205 Wiesbaden (DE)
• Hultzsch, Günter, Dr.
65187 Wiesbaden (DE)
• Joerg, Klaus, Dr.
55218 Ingelheim (DE)

(54) **Mattiertes strahlungsempfindliches Aufzeichnungsmaterial und Verfahren zu dessen Herstellung**

(57) Gegenstand der Erfindung ist ein flächenförmiges strahlungsempfindliches Aufzeichnungsmaterial, das in einem Kontaktkopierverfahren bebildert wird und auf dessen Oberfläche sich eine diskontinuierliche Mattierungsschicht aus monodispersen Partikeln befindet. Die Mattierungsschicht läßt sich durch Aufsprühen einer Mattierungsflüssigkeit herstellen. Geeignet dazu ist eine Vorrichtung, umfassend einen Schwingungserzeuger, der Schwingungen auf die Flüssigkeit in der Vorrichtung übertragen kann, und eine Lochblende, die mindestens eine Bohrung mit einem Durchmesser von 5 bis 250 µm aufweist, aus der die Flüssigkeit in Form mindestens eines laminaren Freistrahls austritt, der in monodisperse Tropfen zerfällt. Der Schwingungserzeuger ist bevorzugt eine Piezokeramik.

EP 0 762 211 A1

**Beschreibung**

Die Erfindung betrifft ein flächenförmiges strahlungsempfindliches Aufzeichnungsmaterial, das in einem Kontaktkopierverfahren bebildert wird und auf dessen Oberfläche sich eine diskontinuierliche Mattierungsschicht befindet, sowie ein Verfahren zum Aufbringen der Mattierungsschicht.

Mattierungsschichten sind insbesondere bei Kontaktkopierverfahren gebräuchlich. In diesen Verfahren wird die Vorlage unmittelbar auf das strahlungsempfindliche Aufzeichnungsmaterial gelegt, gewöhnlich in einem sogenannten Vakuum-Kontaktkopierrahmen. Der direkte Kontakt zwischen Vorlage und Aufzeichnungsmaterial wird hergestellt, indem die dazwischen befindliche Luft abgesaugt wird. Bei sehr glatten Oberflächen dauert es jedoch lange, bevor ein konstantes Vakuum erreicht ist. Außerdem können Lufteinschlüsse zurückbleiben, die zu einem Unterstrahlen führen. Viele Aufzeichnungsmaterialien enthalten zudem Verbindungen, die bei Bestrahlung chemisch reagieren und dabei Gase, beispielsweise Stickstoff, freisetzen. Die Entfernung solcher Gase bereitet bei glatten Oberflächen ebenfalls Probleme.

Diese Nachteile lassen sich weitgehend vermeiden, wenn Kopiermaterialien mit rauher Oberfläche verwendet werden. Eine solche Oberfläche läßt sich beispielsweise durch Bepudern der strahlungsempfindlichen Schicht mit einem feinteiligen Pulver erzielen. Dies führt jedoch in der Regel zu einer ungleichmäßigen Rauhigkeit. Außerdem kann sich das Pulver von der Oberfläche ablösen und die Vakuumpumpe verunreinigen.

Eine rauhe Oberfläche erhält man auch, wenn das Aufzeichnungsmaterial mit einer Walze geprägt wird.

Anorganische oder organische Teilchen einer bestimmten Größe, die man der Lösung oder Dispersion, die zur Herstellung der strahlungsempfindlichen Schicht dient, zusetzen kann, ragen nach dem Trocknen aus der fertigen Schicht heraus und bewirken ebenfalls eine rauhe Oberfläche. Wenn sich diese Teilchen in der Kopierschicht befinden, spricht man von einer "Mikropigmentierung"; sind sie jedoch auf der Kopierschicht, spricht man von "Mattierung".

Mattierungsschichten lassen sich unterteilen in solche, die die Oberfläche vollständig bedecken (= kontinuierliche Mattierungsschichten) und solche, die die Oberfläche nur teilweise bedecken (= diskontinuierliche Mattierungsschichten). Die diskontinuierlichen Schichten bestehen häufig aus mehr oder weniger halbkugelförmigen Erhebungen (= "Kalotten").

Aus der DE-A 30 03 131 (= US-A 4 288 521) ist das Aufstäuben mit Hilfe eines Zyklons und anschließende thermische oder chemische Fixieren von festen Mattierungsmitteln zur Erzeugung von diskontinuierlichen Schichten bekannt.

Gemäß der DE-A 26 06 793 (= US-A 4 216 289) ist eine Mattierung möglich, indem eine Beschichtungslösung über eine Prägewalze auf eine Beschichtungswalze aufgebracht wird, die aus elastischem Material mit feinem, unebenem Muster besteht. Von dieser Beschichtungswalze wird die Beschichtungslösung dann auf einen Träger übertragen.

In der DE-A 31 31 570 (= GB-A 2 081 919) ist offenbart, eine wäßrige Flüssigkeit aufzusprühen, die ein Harz in gelöster oder dispergierter Form enthält. Das Aufsprühen kann durch Anlegen einer elektrostatischen Spannung von mindestens 5 kV unterstützt werden (EP-A 0 344 985, EP-A 0 649 063).

Höhe, Durchmesser und Anzahl der Mattierungspartikel pro Flächeneinheit sind jedoch bei all diesen Verfahren gewissen Schwankungen unterworfen, so daß das Verhalten beim Kontaktkopieren nicht sicher reproduzierbar ist.

Aufgabe der vorliegenden Erfindung war es daher, eine Mattierung zur Verfügung zu stellen, bei der die oben geschilderten Probleme nicht mehr auftreten.

Gelöst wird die Aufgabe dadurch, daß eine Lösung oder Dispersion eines Harzes in Form von monodispersen Tropfen aufgesprüht wird. "Monodispers" bedeutet, daß die Tropfen im wesentlichen gleich groß sind, also das Flüssigkeitsspray keine breite Tropfenverteilung aufweist. Auch die Geschwindigkeit, mit der sich die Tropfen auf die Oberfläche zubewegen, ist praktisch bei allen Tropfen gleich. Dementsprechend sind die Mattierungspartikel ("Kalotten"), die aus den auf die Oberfläche aufgesprühten Tropfen nach dem Trocknen entstehen, im wesentlichen gleich groß. "Monodispers" im mathematischen Sinn ist ein Partikelkollektiv mit der Verteilungsbreite Null. Alle anderen Partikelkollektive sind demgegenüber "polydispers". In der Realität gibt es jedoch keine mathematisch monodispersen Partikelkollektive. In der Praxis ist es daher üblich, ein Partikelkollektiv, dessen mittlere Durchmesser weniger als 10 % voneinander abweichen, als "monodispers" zu bezeichnen (VDI-Richtlinien, Nr. 3491 [1980], Punkt 3.3.7). Diese Definition soll auch in der vorliegenden Anmeldung gelten.

Gegenstand der vorliegenden Erfindung ist somit ein flächenförmiges strahlungsempfindliches Aufzeichnungsmaterial, das in einem Kontaktkopierverfahren bebildert wird und auf dessen Oberfläche sich eine diskontinuierliche Mattierungsschicht befindet. Es ist dadurch gekennzeichnet, daß die Mattierungsschicht aus monodispersen Partikeln besteht. Die Partikel sind auf der Oberfläche zudem in praktisch gleichen Abständen zueinander angeordnet.

Das Aufzeichnungsmaterial liegt in der Regel in Form von Platten, Folien oder Bändern vor. Es umfaßt allgemein einen Träger, der aus Metall, Kunststoff oder anderem Material bestehen kann, und eine strahlungsempfindliche Schicht. Besonders bevorzugt sind strahlungsempfindliche Aufzeichnungsmaterialien mit einem Träger aus einer Metall- oder Kunststoffolie, bevorzugt einer Aluminium- oder Polyesterfolie, auf der sich eine strahlungsempfindliche Schicht befindet. Im letzteren Fall kann sich die diskontinuierliche, monodisperse Mattierungsschicht auf der strahlungsempfindlichen Schicht wie auch auf der nichtbeschichteten Rückseite der Kunststoffolie befinden. Voraussetzung ist dann jedoch, daß die Kunststoff-Trägerfolie für die bildmäßig einwirkende Strahlung durchlässig ist. Die diskontinuierliche Mattierungsschicht aus den monodispersen Partikeln ist stets auf der Seite des Aufzeichnungsmaterials angeordnet, die mit der Bildvorlage in Kontakt tritt. Das Aufzeichnungsmaterial ist beispielsweise ein Lichtpausmaterial oder ein Vesikularfilm (Vesikularfilme werden beispielsweise zur Mikrofilmduplizierung eingesetzt). Weitere Beispiele sind Aufzeichnungsmaterialien, aus denen sich Farbprüffolien für den Mehrfarbendruck oder Druckformen herstellen lassen. Durch die erfindungsgemäße Mattierungsschicht wird ein enger, gleichmäßiger Kontakt zwischen der Filmvorlage und dem Aufzeichnungsmaterial gewährleistet. Zudem verhindert die Mattierung ein unerwünschtes Haften ("Blocken") der Filmvorlage an dem Aufzeichnungsmaterial. Das Blocken ist ein bei glatten Folien allgemein auftretendes Problem.

Erfindungsgegenstand ist schließlich auch ein Verfahren zur Erzeugung der erfindungsgemäßen mattierten Aufzeichnungsmaterialien, das dadurch gekennzeichnet ist, daß eine Mattierungsflüssigkeit in Form monodisperser Tropfen aufgesprüht wird. Üblicherweise wird nach dem Aufsprühen noch getrocknet. Die Trocknung erfolgt meist in einem Konvektionstrockner oder durch Infrarotbestrahlung.

Eine Vorrichtung, mit der sich die Mattierung des erfindungsgemäßen Aufzeichnungsmaterials aufsprühen läßt, ist in der DE-A 44 41 553 beschrieben. Sie arbeitet nach dem Prinzip des gesteuerten Zerfalls von Flüssigkeitsstrahlen. Gasblasen in der Flüssigkeit in der Vorrichtung würden zu Funktionsstörungen führen. Sie sollten daher entfernt werden. In der Flüssigkeitssäule in der Vorrichtung werden Longitudinal-Schwingungen angeregt. Die Frequenz dieser Schwingungen liegt bevorzugt bei 1 bis 200 kHz, besonders bevorzugt bei 2 bis 150 kHz. Erzeugt werden die Schwingungen vorteilhaft mit Hilfe einer Piezokeramik. Die Schwingungen bewirken periodische Druckschwankungen in der Flüssigkeitssäule. Die Flüssigkeit tritt schließlich durch die Bohrung(en) einer Lochblende in Form von laminaren Freistrahlen aus, die dann infolge der periodischen Druckschwankungen in eine Kette monodisperser Tropfen zerfallen. Die Lochblende weist entsprechend eine oder mehrere feine Bohrung(en) mit einem Durchmesser (d) von jeweils 5 bis 250 $\mu$m, bevorzugt 10 bis 100 $\mu$m, auf. Diese Bohrungen werden vorzugsweise mit Laserwerkzeugen ausgeführt. Die einzelnen Bohrungen sollen möglichst alle den gleichen Durchmesser haben. Die Frequenz (f) der Longitudinal-Schwingungen in dem Tropfenerzeuger muß an die Geschwindigkeit (U), mit der die Flüssigkeit ausströmt, wie auch an den Durchmesser (d) der Austrittsbohrungen angepaßt sein. Bei einem Durchmesser der Bohrung(en) von 10 $\mu$m liegt die Frequenz im Bereich von 40 bis 130 kHz. Die Flüssigkeitsstrahlen müssen gegen die aufgeprägten Schwingungen (= "Störwellen") instabil sein. Dazu muß die Länge der Störwellen länger sein als der Umfang des Flüssigkeitsstrahls unmittelbar nach dem Austritt aus der Bohrung.

Der Durchmesser ($d_p$) der Tropfen ist von der Frequenz abhängig und läßt sich somit einstellen. Er läßt sich aus dem Volumendurchfluß (Q) der ausströmenden.Flüssigkeit und der Frequenz (f) der aufgeprägten Störwellen mit Hilfe der Gleichung $d_p = (6Q/\pi \cdot f)^{1/3}$ berechnen. Die Bildung von (unerwünschten) kleineren Satellitentropfen zwischen den in gleichem Abstand befindlichen Haupttropfen läßt sich ebenfalls durch geeignete Wahl der Frequenz verhindern., Die Frequenzanpassung ist leicht durchführbar.

Verunreinigungen in der Flüssigkeit können zu einer Verstopfung der Bohrungen in der Lochblende führen. Daher wird zweckmäßig ein entsprechend feines Filter vorgeschaltet. Wenn die Flüssigkeit über eine Membran mit einem Porendurchmesser von nicht mehr als 1,2 $\mu$m filtriert wurde, kann auch eine Lochblende mit Mikrobohrungen von 10 $\mu$m Durchmesser zum Einsatz kommen, ohne daß Verstopfungen zu erwarten sind. Mit der Vorrichtung können Lösungen wie auch Dispersionen zu monodispersen Tropfen geformt werden. Die Dispersionen können dabei bevorzugt Teilchen bis zu einem Durchmesser von einigen hundert Nanometern enthalten.

Der Inklinationswinkel ($\alpha$) zwischen dem Freistrahl und der Normalen der zu mattierenden Fläche liegt zwischen 0 und weniger als 90°, bevorzugt zwischen 0 und 80°. Das bedeutet, die Tropfen müssen nicht stets senkrecht auf die Fläche auftreffen ($\alpha = 0$), sondern können auch schräg auftreffen.

Geschwindigkeit und Durchmesser der Tropfen lassen sich mit Hilfe eines Phasen-Doppler-Anemometers (PDA) bestimmen. Darin werden die Streulichtsignale genutzt, die von den Tropfen beim Durchtritt durch den Kreuzungspunkt von 2 Laserstrahlen ausgesandt werden. Dabei wird vorausgesetzt, daß die Tropfen kugelförmig sind. Diese Bedingung ist erfüllt, wenn die Ohnesorgesche Zahl (Oh) 0,01 oder größer ist. Die laminaren Flüssigkeitsstrahlen sind dann bereits wenige Zentimeter nach Verlassen der Lochblende (1) in eine Kette monodisperser, kugelförmiger Tropfen zerfallen. Oh ist eine Funktion der dynamischen Viskosität ($\mu$), der Oberflächenspannung ($\sigma$) und der Dichte ($\rho$) der Flüssigkeit gemäß der Formel $Oh = \mu/(\sigma \cdot d_p \cdot \rho)^{0,5}$.

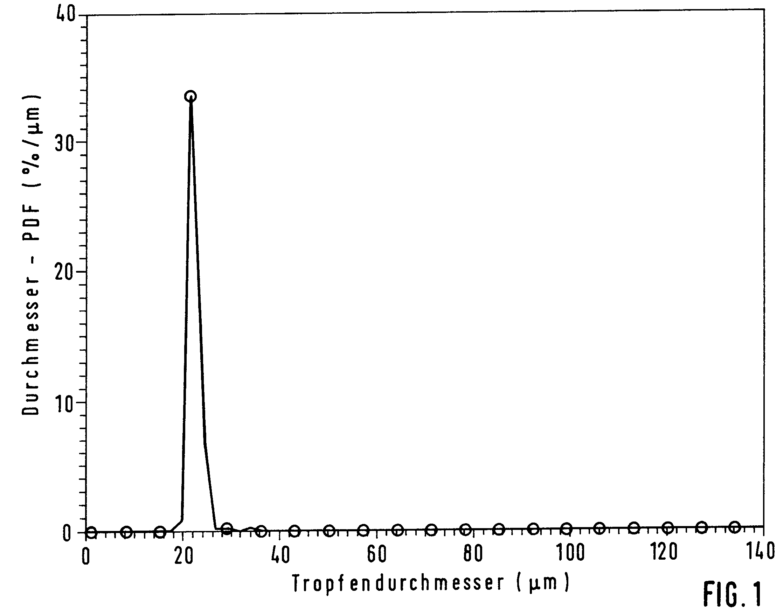

Die Verteilung der Durchmesser ($d_p$) von Tropfen, die aus einer Dispersion mit einem Feststoffanteil von 25 % und einer Blende mit 10 $\mu$m Bohrungen bei einer Frequenz von 124,1 kHz und einer Durchflußrate (Q) von 0,099 ml/min hergestellt wurden, ist in Fig. 1 dargestellt. Der mittlere Tropfendurchmesser ($D_{10}$) beträgt in dem Beispiel 22,8 $\mu$m.

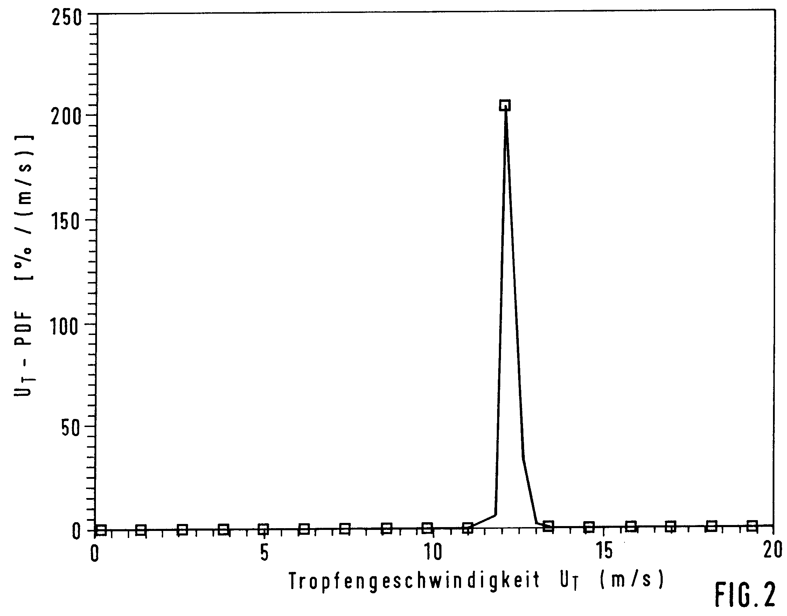

Die zugehörige Verteilung der Geschwindigkeiten ($U_T$) der einzelnen Tropfen ist in Fig. 2 dargestellt. Die mittlere Geschwindigkeit ($U_{mean}$) beträgt 12,3 m/s.

Aus den Figuren wird deutlich, daß die Streuung um den Mittelwert jeweils sehr gering ist.

Der Frequenzbereich ist nach Lage und Breite vorgegeben. Er variiert mit dem Quotienten U/d. Es ist nicht möglich, den Tropfendurchmesser ($d_p$) unabhängig von der Durchflußrate (Q) der Flüssigkeit zu wählen. Der Durchmesser ($d_p$) kann aber je nach Breite des Frequenzbereichs durch Verändern der Frequenz um bis zu ± 20 % variiert werden.

Bandförmige Aufzeichnungsmaterialien werden häufig mit einer Bandgeschwindigkeit ($U_b$) unter dem Tropfenerzeuger hindurch geführt. Die Tropfen treffen dann in einem Abstand ($\delta_T$) auf, der durch die Frequenz (f) und die Bandgeschwindigkeit ($U_b$) bestimmt wird nach der Gleichung $\delta_T = U_b/f$. Ein geringerer Abstand ($\delta_T$) bedeutet eine höhere Belegungsdichte. Soll der Tropfenabstand beispielsweise bei 300 µm liegen, so wäre bei einer Bandgeschwindigkeit ($U_b$) von 1 m/s gemäß der obigen Gleichung eine Frequenz von 3,3 kHz erforderlich. Höhere Frequenzen führen zu kleineren Tropfenabständen und damit zu einer dichteren Belegung. Der Tropfenerzeuger muß folglich über dem bandförmigen Körper in Bandlaufrichtung oder quer dazu hin- und herbewegt werden, um diesen Tropfenabstand zu erzielen. Der Tropfenabstand kann darüber hinaus noch durch die Überlagerung von Drehbewegungen beeinflußt werden.

Sollen breite (evtl. mehrere Meter) bandförmige Aufzeichnungsmaterialien mattiert werden, so werden zweckmäßig entsprechend breite Lochblenden verwendet, in denen die Mikrobohrungen reihenförmig angeordnet sind. Der Abstand der Bohrungen voneinander richtet sich nach der jeweils angestrebten Art der Mattierung. Die Bohrungen müssen dabei über die gesamte Breite gleichmäßig mit Flüssigkeit versorgt werden, damit an allen der gleiche Druck und Volumenstrom herrscht. Dies kann durch eine Verteilkammer erreicht werden. Bei dieser Ausführungsform des Tropfenerzeugers kann die Anregung mit dem Schwingungserzeuger direkt in der Flüssigkeit oberhalb der Verteilkammer erfolgen. Der aus der DE-A 44 41 553 bekannte Tropfenerzeuger kann ebenfalls für breite, bahnförmige Körper verwendet werden. Er muß dann allerdings beweglich angeordnet sein, um eine gleichmäßige Belegung mit den Tropfen sicherzustellen. Hierbei wird der Tropfenerzeuger eine Scanning-Bewegung ausführen.

Die erfindungsgemäßen Aufzeichnungsmaterialien besitzen eine extrem gleichmäßige Mattierung. Dies gilt sowohl für den Abstand wie auch für die Höhe und den Durchmesser der Mattierungspartikel. Auch großflächige Rasterpartien - selbst unter kritischen Bedingungen - exakt übertragen, ohne daß es zu nennenswertem Unterstrahlen kommt. Die Mattierungspartikel haben in diesem Fall eine Höhe von vorzugsweise nicht mehr als 10 µm. Bei einer Höhe von mehr als 10 µm ist die Wiedergabe von Feinzeichnungen der Filmvorlage verschlechtert. Auf jedem Quadratzentimeter des Aufzeichnungsmaterials befinden sich vorzugsweise etwa 100 bis 10.000 Kalotten in einem gleichmäßigen Abstand von 1.000 bis 100 µm.

Die Lösung oder Dispersion, aus der die monodispersen Tropfen hergestellt werden, enthält allgemein 0,5 bis 50 Gew.-%, bevorzugt 5 bis 40 Gew.-%, an Feststoff, bezogen auf ihr Gesamtgewicht. Der Feststoffanteil hängt ab von der Art des Lösemittels bzw. von der Art der äußeren Phase (im Fall der Dispersion), von der Strecke, die die monodispersen Tropfen zurücklegen müssen, von der Umgebungstemperatur, der Weite der Mikrobohrung(en), der Frequenz des Schwingungserzeugers sowie von der angestrebten Größe der Mattierungspartikel. Der Siedepunkt des Lösemittels bzw. der äußeren Phase liegt vorzugsweise bei etwa 40 bis 250 °C. Neben Wasser sind dabei auch organische Lösemittel, wie Aliphaten, Aromaten, Ketone (z. B. Aceton), Ether (z. B. Tetrahydrofuran), Glykolether (insbesondere Ethylenglykol- oder Propylenglykol-mono- oder -di($C_1$-$C_4$)alkylether) oder polar-aprotische Lösemittel (z. B. N-Methylpyrrolidon, Dimethylformamid, gamma-Butyrolacton oder Dimethylsulfoxid) geeignet.

Der Feststoff beinhaltet in der Regel ein organisches Polymer (= Harz). Das Polymer hat vorzugsweise eine Glas-Übergangstemperatur von mindestens 40 °C, um ein unerwünschtes Kleben bei der nachfolgenden Verarbeitung zu vermeiden. Besonders geeignet sind Polykondensate, wie Polyester, Polyamide, Polyurethane oder Polyharnstoffe. Daneben sind auch Polymerisate, insbesondere Homo- und Copolymere mit Einheiten aus Acryl- oder Methacrylaten, Vinylaromaten, Vinylethern, Vinylalkoholen, Vinylacetalen und Vinylamiden, geeignet.

Strahlungsempfindliche Aufzeichnungsmaterialien, insbesondere solche zur Herstellung von Offsetdruckformen, werden nach der bildmäßigen Bestrahlung allgemein mit einem wäßig-alkalischen Entwickler entwickelt. Damit der Entwickler dabei gleichzeitig auch die Mattierungsschicht entfernt, werden bevorzugt Harze verwendet, die Säure- und/oder Salzgruppen enthalten. Bei den Salzen handelt es sich meist um Natrium-, Kalium, Ammonium-, Calcium-, Zink- oder Aluminiumsalze. Bevorzugt haben die Harze einen Gehalt an Säure und/oder Salzgruppen von 0,03 bis 0,75 mmol/g. Solche Harze sind in der EP-A 0 649 063 beschrieben.

Daneben kann die Lösung oder Dispersion noch Tenside, - insbesondere anionische und/oder nichtionische - enthalten, die das Benetzungsverhalten auf der Oberfläche des Aufzeichnungsmaterials beeinflussen.

Die nachfolgenden Beispiele sollen die Erfindung näher erläutern ohne sie einzuschränken. Soweit nicht anders angegeben, sind die Mengen in Gewichtsteilen (Gt) aufgeführt. Der Inklinationswinkel $\alpha$ ist gleich Null in allen folgenden Beispielen.

## Beispiel 1

(Trocken entwickelbares Colorproof-Material)

50 µm dicke, beidseitig haftvermittelnd vorbehandelte, biaxial verstreckte und triermofixierte Polyesterfolien (($^R$)Melinex 505) wurden jeweils mit einer der folgenden vier strahlungsempfindlichen Gemische beschichtet:

| | Cyan | Magenta | Gelb | Schwarz |
|---|---|---|---|---|
| Dipentaerythritpentaacrylat | 19,9 | 25,0 | 21,6 | 19,9 |
| 2,3-Bis-(4-methoxyphenyl)-chinoxalin | 5,1 | 6,1 | 5,4 | 5,3 |
| Polyvinylformal | 16,3 | 23,0 | 18,4 | 14,2 |
| polyethermodifiziertes Polysiloxan* | 0,2 | 0,2 | 0,2 | 0,2 |
| (R)Hostapermblau B2G (C.I. 74160) | 9,7 | - | - | - |
| Permanent Rot FBB (C.I. 12485) | - | 12,9 | - | - |
| Permanent Gelb (C.I. 21100) | - | - | 8,6 | - |
| Ruß ((R)Printex 25) | - | - | - | 13,6 |
| Tetrahydrofuran | 398,6 | 363,9 | 382,4 | 378,8 |
| Diacetonalkohol | 113,9 | 121,3 | 124,3 | 123,1 |
| 1-Methoxy-2-propanol | 360,6 | 326,5 | 353,7 | 331,5 |
| gamma-Butyrolacton | 75,9 | 121,3 | 86,0 | 113,6 |

* mit einem Molekulargewicht $M_w$ von 6500, bestimmt durch Gelpermeations-Chromatographie (GPC).

Dabei wurden die Pigmente mit einem Teil des Bindemittels und des Butyrolactons dispergiert. Die Teilchengröße betrug weniger als 200 nm.

Nach dem Trocknen bei 110 °C betrug das Gewicht der aufgebrachten Schicht etwa 0,7 g/m$^2$. Auf die getrocknete strahlungsempfindliche Schicht wurde dann jeweils eine Lösung aus

| 50 Gt | Vinylacetat/Crotonsäure-Copolymer (95/5), |
|---|---|
| 252 Gt | Wasser, |
| 24 Gt | Ethanol und |
| 5 Gt | 25 gew.-%-iger wäßriger Ammoniaklösung |

aufgetragen und bei 100 °C getrocknet. Das Gewicht der so aufgetragenen Haftschicht betrug dann 6 g/m$^2$. Auf diese Haftschicht wurde schließlich noch eine transparente Schutzfolie aufkaschiert.

Danach wurde jeweils die Hälfte der Rückseite der Trägerfolie mit einer erfindungsgemäßen diskontinuierlichen Mattierungsschicht versehen. Die andere Hälfte blieb zu Vergleichszwecken unmattiert.

Mattiert wurde mit einer wäßrigen Dispersion mit etwa 20 Gew.-% Feststoffanteil. Der Feststoffanteil bestand im wesentlichen aus einem Copolymer aus

| 80 Gew.-% | Vinylidenchlorid, |
|---|---|
| 5 Gew.-% | Acrylnitril, |
| 12 Gew.-% | Methylmethacrylat und |
| 3 Gew.-% | Acrylsäure. |

Stabilisiert war die Dispersion mit Dodecylbenzolsulfonat. Die dynamische Viskosität ($\mu$) der Dispersion betrug 3 mPa·s, ihre Dichte ($\rho$) 1,1 g/ml und ihre Oberflächenspannung 43 mN/m.

Der Tropfengenerator wurde in einer Scanning-Bewegung über die Folien geführt. Die Lochblende des Tropfengenerators hatte einen Durchmesser von 10 µm. Angeregt wurde die Dispersion in dem Tropfengenerator mit einer Frequenz von 39,7 kHz. Der mittlere Tropfendurchmesser ($D_{10}$) betrug 40,2 µm, der Abstand ($\delta_T$) der Kalotten untereinander auf der Folienoberfläche 200 µm, die größte Höhe der Kalotten über der Folienoberfläche 3 µm und der Durchmesser (s) der Kalotten 75 µm.

Verarbeitung der Farbprüffolien :

Nach dem Abziehen der Schutzfolie wurde die Farbfolie bei 85 °C auf kunststoffbeschichtetes Spezialpapier laminiert und unter einem Positiv-Film, 60er-Raster, mit 20 % Flächendeckung in Kontaktkopie belichtet. Nach dem Abziehen der Trägerfolie unter einem Winkel von 180° wurde das entsprechende Farbprüfbild erhalten. Bei allen 4 Farben zeigte sich das gleiche Resultat: die Hälfte, die durch die mattierte Trägerfolie belichtet worden war, zeigte eine gleichmäßige Rasterwiedergabe, während in der anderen Hälfte, die durch die unmattierte Trägerfolie belichtet worden war, eine deutliche Rasterunruhe festzustellen war.

Beispiel 2

(Vesicularfilmmaterial)

Auf eine 125 μm dicke, biaxial verstreckte und thermofixierte, glasklare Polyethylenterephthalatfolie wurde eine Haftschicht aufgebracht, indem auf die Folie eine Lösung aus

| 1,15 Gt | eines linearen, gesättigten, hydroxylgruppenhaltigen Polyesters ([R]Dynapol LH 812), |
| 0,65 Gt | eines Vinylidenchlorid/Acrylnitril-Copolymers (70/30) ([R]Saran F310) und |
| 98,2 Gt | Methylethylketon |

aufgetragen und bei 110 °C getrocknet wurde. Das Gewicht der Haftschicht betrug danach ca. 0,25 g/m$^2$. Auf die getrocknete Haftschicht wurde dann eine Lösung aus

| 12,7 Gt | Vinylidenchlorid/Acrylnitril-Copolymer (30/70), |
| 3,3 Gt | Vinylidenchlorid/Acrylnitril-Copolymer (80/20) |
| 0,8 Gt | 2,5-Diethoxy-4-morpholino-benzoldiazonlum-tetrafluoroborat |
| 0,7 Gt | Citronensäure, |
| 0,3 Gt | Natriumdioctylsulfosuccinat und |
| 83,0 Gt | Methylethylketon |

aufgetragen und bei 100 °C getrocknet. Das Gewicht der so erhaltenen strahlungsempfindlichen Schicht betrug 6 g/m$^2$. Danach wurde auf eine Hälfte dieser Schicht eine erfindungsgemäße diskontinuierliche Mattierungsschicht aufgesprüht. Dazu wurde eine Dispersion mit einem Feststoffanteil von 10 Gew.-%, einer dynamischen Viskosität ($\mu$) von 2,5 mPa·s, einer Dichte ($\rho$) von etwa 1 g/ml und einer Oberflächenspannung ($\sigma$) von 38 mN/m verwendet. Der Feststoff bestand aus einem Methacrylsäure/Styrol/Ethylacrylat-Terpolymer mit einem Methacrylsäuregehalt von 4,6 Gew.-% und einer Glas-Übergangstemperatur ($T_g$) von ca. 75 °C, dispergiert in Wasser als Zink-Ammoniak-Komplexsalz. Die Größe der Teilchen in der Dispersion betrug weniger als 100 nm.

Der Tropfengenerator wurde in einer Scanning-Bewegung über die Folie geführt. Der Durchmesser der Bohrung in der Lochblende (d) betrug 10 μm, die Frequenz (f) 100 kHz, der mittlere Tropfendurchmesser ($D_{10}$) 26 μm, der Abstand der Kalotten auf der Folie ($\delta_T$) 100 μm, die Höhe der Kalotten (h) 2 μm und ihr Durchmesser (s) 40 μm.

Verarbeitung des Vesicularfilms:

Nach dem Belichten unter einem 60er-Raster-Negativ mit 20% Flächendeckung im Kontakt wurde das Material auf 130 °C zur Entwicklung erwärmt. In der durch die Mattierungsschicht belichteten Hälfte des Films war das Raster homogen wiedergegeben. In der anderen Hälfte war dagegen die Rasterfläche inhomogen. Bei Beleuchtung im Durchlicht zeigte sie deutliche Unterschiede in der Transmission.

Beispiel 3

(Lichtpausmaterial)

Auf eine 175 μm dicke, biaxial verstreckte und thermofixierte, glasklare Polyethylenterephthalatfolie wurde eine Lösung aus

| 0,234 Gt | eines Polyesters aus Terephthalsäure, Neopentylglykol und Ethylenglykol, mittleres Molekulargewicht $M_w$ 19.000 (bestimmt durch GPC), |
| 10,0 Gt | eines Esters aus Cellulose, Essigsäure und Propionsäure (3,5% der Hydroxygruppen der Cellulose waren mit Essigsäure verestert, 45% mit Propionsäure), |
| 0,13 Gt | Vinylidenchlorid/Acrylnitril-Copolymer (80/20) und |
| 240 Gt | Ethylenglykol-monomethylether |

EP 0 762 211 A1

aufgetragen und bei 120 °C getrocknet. Das Gewicht der so hergestellten Haftschicht betrug danach etwa 3 g/m$^2$. Auf die Haftschicht wurde dann eine Lösung aus

| | |
|---|---|
| 3,5 Gt | des o.g. Cellulose-acetat-propionats, |
| 1,3 Gt | 2-Hydroxy-N-(2-hydroxy-ethyl)-naphthalin-3-carbonsäureamid, |
| 2,3 Gt | 2,5-Dibutoxy-4-morpholino-benzoldiazonium-tetrafluoroborat, |
| 0,1 Gt | 2-Hydroxy-5-sulfo-benzoesäure (= Sulfosalicylsäure), |
| 0,05 Gt | polyethermodifiziertes Polydimethylsiloxan ([R]Edaplan LA 411), |
| 30 Gt | Ethylenglykol-monomethylether und |
| 120 Gt | Tetrahydrofuran, |

aufgetragen und bei 105 °C getrocknet. Das Gewicht der so hergestellten strahlungsempfindlichen Schicht betrug 7,5 g/m$^2$.

Eine Hälfte des strahlungsempfindlichen Aufzeichnungsmaterials wurde anschließend mit einer erfindungsgemäßen diskontinuierlichen Mattierung versehen. Dazu wurde eine Dispersion eines Styrol/Butylacrylat/Natrium-ethylensulfonat-Terpolymers (70/24,4/5,6) in Wasser mit einem Feststoffgehalt von ca. 20 Gew.-%, einer dynamischen Viskosität ($\mu$) von 4,5 mPa·s, einer Dichte ($\rho$) von etwa 1 g/ml und einer Oberflachenspannung ($\sigma$) von 41 mN/m mit dem Tropfengenerator aufgesprüht. Der Tropfengenerator, dessen Lochblende eine Bohrung mit einem Durchmesser von 10 μm aufwies, und der mit einer Frequenz von 45 kHz betrieben wurde, lieferte monodisperse Tropfen mit einem Durchmesser $D_{10}$ von 38 μm. Er wurde in einer Scanning-Bewegung über die Folie geführt. Auf diese Weise wurden auf die Oberfläche der strahlungsempfindlichen Schicht monodisperse Kalotten mit einer mittleren Höhe (h) von 3 μm, einem mittleren Durchmesser (s) von 70 μm und einem mittleren Abstand ($\delta_T$) zueinander von 200 μm aufgebracht.

Verarbeitung der Diazotypie-Folien :

Nach dem Belichten unter einem 60er-Raster-Positiv mit 20 % Flächendeckung im Kontakt erfolgte die Entwicklung trocken mit (gasförmigem) Ammoniak. Wie in den Beispielen 1 und 2 zeigte auch in diesem Fall nur die Hälfte, die durch die Mattierungsschicht hindurch belichtet worden war, eine gleichmäßige Rasterwiedergabe.

Beispiel 4

(Offsetdruckform)

Eine in Salzsäure elektrolytisch aufgerauhte ($R_z$-Wert nach DIN 4768 : 5,0 μm), in Schwefelsäure zwischengebeizte und in Schwefelsäure eloxierte (Oxidgewicht 4,0 g/m$^2$) 0,3 mm dicke Aluminiumfolie wurde mit Polyvinylphosphonsäure hydrophiliert und dann mit einer Lösung aus

| | |
|---|---|
| 5,00 Gt | eines Kresol/Formaldehyd-Novolaks mit einer Hydroxylzahl von 420 nach DIN 53783/53240 und einem mittleren Molekulargewicht $M_w$ von 10.000 (bestimmt durch GPC mit Polystyrol-Standard), |
| 1,20 Gt | eines Esters aus 3 mol 1,2-Naphthochinon-2-diazid-5-sulfonylchlorid und 1 mol 2,3,4-Trihydroxy-benzophenon, |
| 0,15 Gt | 1,2-Naphthochinon-2-diazid-4-sulfonylchlorid, |
| 0,05 Gt | Victoriareinblau (C.I. 44 045) und |
| 0,005 Gt | polyethermodifiziertes Polydimethylsiloxan ([R] Edaplan LA), und |
| 93,595 Gt | eines Gemisches aus Methylethylketon und Propylenglykol-monomethylether (40/60) |

beschichtet und 1 Minute bei 125 °C getrocknet. Das Gewicht der so hergestellten strahlungsempfindlichen Schicht betrug 2,4 g/m$^2$.

Anschließend wurde das so hergestellte Aufzeichnungsmaterial in 3 Teile geschnitten. Teil A wurde nicht weiter nachbehandelt, während die Teile B und C mattiert wurden, und zwar mit einer Dispersion, die 20 Gew.-% Feststoff in Wasser dispergiert enthielt. Der Feststoff war im wesentlichen ein Methacrylsäure/Methylmethacrylat/Ethylacrylat-Terpolymer mit einem Methacrylsäuregehalt von 4,6 Gew.-%. Stabilisiert war die Dispersion mit dem Natriumsalz der Nonylphenoloctaglykolsulfonsäure. Die Dispersion hatte eine dynamische Viskosität ($\mu$) von 3,0 mPa·s, eine Dichte ($\rho$) von etwa 1 g/ml und eine Oberflächenspannung ($\sigma$) von 39 mN/m.

Auf Teil B wurde die Dispersion in bekannter Weise (EP-A 0 649 063) mit einer auf hoher Drehzahl rotierenden Sprühglocke ("Hochrotationsglocke") mit elektrostatischer Unterstützung aufgesprüht. Benutzt wurde eine Sprühglocke mit einem Durchmesser von, 6 cm und einer Drehzahl von 20.000 pro min. Der Abstand zwischen der Sprühglocke und der Oberfläche des Aufzeichnungsmaterials betrug 15 cm. Zwischen Glocke und Aufzeichnungsmaterial lag eine elektrostatische Potentialdifferenz von 40 kV. Die so hergestellte diskontinuierliche Mattierungsschicht wurde anschließend mit Infrarotstrahlung getrocknet.

Auf jeden Quadratzentimeter der Mattierungsschicht entfielen im Durchschnitt 2.300 Kalotten, deren mittlere Höhe 4 µm und deren maximale Höhe 9 µm betrug. Der mittlere Durchmesser der Kalotten betrug 35 µm, der maximale Durchmesser 70 um. Die Mattierung war also nicht "monodispers".

Teil C wurde mit Hilfe des Tropfengenerators mit der erfindungsgemäßen Mattierung versehen. Der Tropfengenerator wurde dabei in einer Scanning-Bewegung über das Aufzeichnungsmaterial geführt. Der Durchmesser (d) der Bohrung in der Lochblende des Tropfengenerators betrug 10 µm, die Anregungsfrequenz (f) 100 kHz, der mittlere Tropfendurchmesser ($D_{10}$) 26 µm, der Abstand ($\delta_T$) der Kalotten zueinander 150 µm, die Höhe der Kalotten 4 µm und ihr Durchmesser (s) 40 µm. Die Mattierungsschicht wurde wie bei dem Teil B getrocknet.

Nach Belichtung unter der 60er-Raster-Positiv-Testvorlage mit 20 % Flächendeckung im Kontakt wurden die Teile A, B und C in einem Tauchbad-Entwicklungsgerät innerhalb von 20 Sekunden mit einem wäßrig-alkalischen Entwickler, der

| 0,45 mol/l | $Na_2SiO_3$ |
| 10 g/l | Benzoesäure und |
| 1 g/l | Nonylphenolethoxylat mit einem HLB-Wert von 13 (HLB = Hydrophilic-Lipophilic-Balance) |

enthielt, jeweils zu einer Offsetdruckform entwickelt.

Ein Vergleich der drei auf diese Weise erhaltenen Druckformen ergab folgendes Resultat:

Platte A zeigte eine starke Rasterunruhe und war damit nicht zufriedenstellend.
Platte B zeigte eine zwar geringere, aber dennoch erkennbare Rasterunruhe und war damit ebenfalls noch nicht zufriedenstellend.
Allein auf der Platte C war das Raster homogen wiedergegeben.

## Patentansprüche

1. Flächenförmiges strahlungsempfindliches Aufzeichnungsmaterial, das in einem Kontaktkopierverfahren bebildert wird und auf dessen Oberfläche sich eine diskontinuierliche Mattierungsschicht befindet, dadurch gekennzeichnet, daß die Mattierungsschicht aus monodispersen Partikeln besteht.

2. Aufzeichnungsmaterial gemäß Anspruch 1, dadurch gekennzeichnet, daß die diskontinuierliche Mattierungsschicht aus den monodispersen Partikeln auf der Seite angeordnet ist, die mit der Bildvorlage in Kontakt tritt.

3. Aufzeichnungsmaterial gemäß Anspruch 1 oder 2, dadurch gekennzeichnet, daß es einen Träger, bevorzugt aus Metall oder Kunststoff, und eine strahlungsempfindliche Schicht umfaßt.

4. Aufzeichnungsmaterial gemäß einem oder mehreren der Ansprüche 1 bis 3, dadurch gekennzeichnet, daß der Träger eine Aluminiumfolie oder eine Polyesterfolie ist.

5. Verfahren zur Erzeugung einer diskontinuierlichen Mattierungsschicht auf einem Formkörper, dadurch gekennzeichnet, daß eine Mattierungsflüssigkeit in Form monodisperser Tropfen aufgesprüht wird.

6. Verfahren gemäß Anspruch 5, dadurch gekennzeichnet, daß die Mattierungsflüssigkeit aufgesprüht wird mit Hilfe einer Vorrichtung, umfassend einen Schwingungserzeuger, der Schwingungen auf die Flüssigkeit in der Vorrichtung übertragen kann, und eine Lochblende, die mindestens eine Bohrung mit einem Durchmesser von 5 bis 250 µm aufweist, aus der die Flüssigkeit in Form mindestens eines laminaren Freistrahls austritt, der in monodisperse Tropfen zerfällt.

7. Verfahren gemäß Anspruch 5 oder 6, dadurch gekennzeichnet, daß der Schwingungserzeuger eine Schwingung mit einer Frequenz von 1 bis 200 kHz, bevorzugt 2 bis 150 kHz, auf die Flüssigkeit überträgt.

8. Verfahren gemäß einem oder mehreren der Ansprüche 5 bis 7, dadurch gekennzeichnet, daß der Schwingungserzeuger eine Piezokeramik ist.

9. Verfahren gemäß einem oder mehreren der Ansprüche 5 bis 8, dadurch gekennzeichnet, daß der Durchmesser der einzelnen Bohrung 10 bis 100 µm beträgt.

**10.** Verfahren gemäß einem oder mehreren der Ansprüch 5 bis 9, dadurch gekennzeichnet, daß die Mattierungsflüssigkeit eine Lösung oder Dispersion ist.

**11.** Verfahren gemäß Anspruch 10, dadurch gekennzeichnet, daß der, Siedepunkt des Lösemittels oder der äußeren Phase in der Lösung oder Dispersion bei etwa 40 bis 250 °C liegt.

**12.** Verfahren gemäß Anspruch 10 oder 11, dadurch gekennzeichnet, daß die Ohnesorgesche Zahl (Oh) der Lösung oder Dispersion 0,01 oder größer ist.

**13.** Verfahren gemäß einem oder mehreren der Ansprüche 10 bis 12, dadurch gekennzeichnet, daß die Lösung oder Dispersion 0,5 bis 50 Gew.-%, bevorzugt 5 bis 40 Gew.-%, an Feststoff, bezogen auf ihr Gesamtgewicht, enthält.

**14.** Verfahren gemäß Anspruch 13, dadurch gekennzeichnet, daß der Feststoff ein organisches Polymer, bevorzugt ein Polymer mit einer Glas-Übergangstemperatur $T_g$ von mindestens 40 °C, beinhaltet.

**15.** Verfahren gemäß einem oder mehreren der Ansprüche 5 bis 14, dadurch gekennzeichnet, daß der Inklinationswinkel ($\alpha$) zwischen dem Freistrahl und der Normalen der zu mattierenden Fläche zwischen 0 und weniger als 90°, bevorzugt zwischen 0 und 80°, liegt.

**16.** Verfahren gemäß einem oder mehreren der Ansprüche 5 bis 15, dadurch gekennzeichnet, daß die Mattierungsschicht nach dem Aufsprühen getrocknet wird.

FIG. 1

EP 0 762 211 A1

FIG.2

Europäisches Patentamt

## EUROPÄISCHER RECHERCHENBERICHT

Nummer der Anmeldung

EP 96 11 3802

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| D,X<br><br>Y | EP-A-0 344 985 (VICKERS PLC) 6.Dezember 1989<br>* Spalte 3, Zeile 33 - Spalte 4, Zeile 17 *<br><br>* Spalte 4, Zeile 37 - Zeile 53 *<br>* Beispiele 2-4 *<br>--- | 1-5,<br>10-14,16<br>6-9,15 | G03F7/115 |
| X<br><br>Y | EP-A-0 429 234 (DU PONT HOWSON LTD) 29.Mai 1991<br>* Seite 5, Zeile 2 - Zeile 26 *<br>* Seite 2, Zeile 49 - Zeile 55 *<br>--- | 1-5,<br>10-14,16<br>6-9,15 | |
| Y | DE-A-19 36 518 (MEAD CORPORATION) 30.April 1970<br>* das ganze Dokument *<br>--- | 6-9,15 | |
| D,Y | DE-A-44 41 553 (BRENN GUENTER DR ING ;DURST FRANZ PROF DR DR H C (DE)) 14.Juni 1995<br>* das ganze Dokument *<br>--- | 6-9,15 | |
| A | DE-A-33 04 648 (FUJI PHOTO FILM CO LTD) 18.August 1983<br>--- | | RECHERCHIERTE SACHGEBIETE (Int.Cl.6)<br><br>G03F |
| A | US-A-3 790 079 (BERGLUND R ET AL) 5.Februar 1974<br>----- | | |

Der vorliegende Recherchenbericht wurde für alle Patentansprüche erstellt

| Recherchenort | Abschlußdatum der Recherche | Prüfer |
|---|---|---|
| DEN HAAG | 20.November 1996 | Haenisch, U |